# EUROPEAN PATENT SPECIFICATION

(11) **EP 3 923 285 B1**
(45) Date of publication and mention of the grant of the patent: **14.06.2023**
(21) Application number: 20914624.0
(22) Date of filing: 28.06.2020
(51) Int. Cl.: G11C 5/02, G11C 7/10, G11C 11/4093, G11C 5/06, G11C 5/04, G11C 7/02, G11C 7/04, G11C 7/22

(54) **INTEGRATED CIRCUIT STRUCTURE AND MEMORY**
INTEGRIERTE SCHALTUNGSSTRUKTUR UND SPEICHER
STRUCTURE DE CIRCUIT INTÉGRÉ ET MÉMOIRE

(30) Priority: 14.01.2020 CN 202010036694; 14.01.2020 CN 202020082043 U
(43) Date of publication of application: 15.12.2021
(73) Proprietor: Changxin Memory Technologies, Inc., Hefei, Anhui 230601 (CN)
(72) Inventor: ZHANG, Liang, Hefei, Anhui 230601 (CN)
(74) Representative: V.O.
(86) International application number: PCT/CN2020/098521
(87) International publication number: WO 2021/143050

(56) References cited:
- CN-A- 1 819 196
- CN-A- 101 620 877
- CN-A- 109 891 586
- CN-U- 210 805 229
- CN-U- 210 805 230
- KR-A- 20040 107 244
- US-A- 6 097 883
- US-A1- 2015 106 538
- US-A1- 2018 130 739
- US-B1- 6 351 405

## Description

### TECHNICAL FIELD

The present disclosure relates to the field of semiconductor memory technologies, and more particularly to an integrated circuit structure and a memory.

### BACKGROUND

With the development of memory technologies, Double Data Rate Fourth Synchronous Dynamic Random Access Memory (DDR4 SDRAM) emerges as the times require. The DDR4 SDRAM has a low power supply voltage and a high transmission rate, and a bank group thereon has characteristics of independently starting operations such as read and write operations. In addition, compared to memories such as DDR3/DDR2, the DDR4 SDRAM not only has fast and power-saving characteristics, but also can enhance signal integrity and improve the reliability of data transmission and storage.

Taking a low-power memory chip LPDDR4 as an example, in an advanced transmission process of the write operation, a data strobe signal (DQS) and a data signal (DQ) are transmitted to the LPDDR4 at an approximately equal speed through a transmission path having an approximately equal length. In the LPDDR4, a DQS input circuit module transmits the received DQS signal as a strobe sample to a DQ input circuit module to collect data. It takes a while to transmit the DQS signal to the DQ input circuit module, which causes the DQS signal to be out of sync with the DQ signal.

To compensate for the time difference between the DQS signal and the DQ signal, the DQS signal may be transmitted in advance. For this reason, in JEDEC standards, a parameter tDQS2DQ is defined to represent the advanced time of transmission.

However, since the tDQS2DQ has a large value, it is susceptible to temperature and voltage interferences in the transmission path, and the performance of the memory is influenced.

It should be illustrated that the information disclosed in the above background part is merely used for enhancing understanding for the background of the present disclosure, and thus cannot constitute information of the prior art known by those skilled in the art.

The related technologies are known from US2015/106538A1 and US2018/130739 A1.

### SUMMARY

The invention is set out in the appended set of claims.

An objective of the present disclosure is to provide an integrated circuit structure and a memory to overcome, to at least some extent, the problem that the tDQS2DQ value is large and it is susceptible to temperature and voltage interferences on a transmission path caused by limitations and defects of related technologies.

According to a first aspect of the present disclosure, an integrated circuit structure is provided, which includes a pad region and a circuit region.

The pad region includes multiple signal pads arranged along a target direction.

The circuit region is arranged on one side of the pad region, and includes multiple input/output circuit modules which are arranged along the target direction and correspondingly connected to the signal pads. Each of the input/output circuit modules is configured to perform a sampling operation on an input signal and write a sampling result into a storage array, and read data stored in the storage array;

A size of the circuit region along the target direction is less than that of the pad region along the target direction.

Optionally, the multiple signal pads include: a first differential data strobe pad, a second differential data strobe pad, a data mask pad, and multiple data input/output pads.

Optionally, the pad region further includes multiple power source pads and multiple ground pads.

Optionally, the pad region includes a first pad subregion and a second pad subregion. The first pad subregion and the second pad subregion includes the same number of data input/output pads, and the number is half of the total number of data input/output pads;

The first differential data strobe pad, the second differential data strobe pad and the data mask pad are arranged between the first pad subregion and the second pad subregion.

Optionally, the multiple input/output circuit modules include a data strobe input/output circuit module, a data mask input/output circuit module, and multiple data input/output circuit modules.

Optionally, the circuit region comprises a first circuit subregion and a second circuit subregion. The first circuit subregion and the second circuit subregion include the same number of data input/output circuit modules, and the number is half of the total number of data input/output circuit modules;

The data strobe input/output circuit module and the data mask input/output circuit module are arranged between the first circuit subregion and the second circuit subregion.

Optionally, the data strobe input/output circuit module is connected to the first differential data strobe pad and the second differential data strobe pad respectively.

Optionally, a distance between the adjacent input/output circuit modules is less than a distance threshold.

The distance threshold is determined based on the size of the pad region along the target direction and the size of each of the multiple input/output circuit modules along the target direction.

A width-to-depth ratio of a region occupied by each of the input/output circuit modules along the target direction is less than a ratio threshold.

According to an aspect of the present disclosure, a memory is provided, which includes the integrated circuit structure according to any one of the above embodiments.

In the technical solutions provided by some embodiments of the present disclosure, a size of a circuit region along a target direction is designed to be less than that of a pad region along the target direction. Compared with the existing technologies, in one aspect, a length of a path for transmitting a DQS signal to a DQ input circuit module is reduced, and further the tDQS2DQ value is reduced. In another aspect, a shorter path can alleviate the temperature and voltage interferences, which can greatly improve temperature and voltage performances and can reduce current consumption, thereby ensuring signal integrity and improving memory performance.

It is to be understood that the above general description and the following detailed description are merely exemplary and explanatory, and are not intended to limit the present disclosure.

### BRIEF DESCRIPTION OF THE DRAWINGS

The accompanying drawings herein, which are incorporated in and constitute a part of this specification, illustrate embodiments consistent with the present disclosure and, together with the specification, serve to explain the principles of the present disclosure. It is apparent to those of ordinary skill in the art that the drawings in the following description only illustrate some embodiments of the present disclosure, and other drawings may be obtained by those of ordinary skill in the art from these drawings without any creative effort. In the drawings,
FIG 1 illustrates a schematic structural diagram of an integrated circuit in some technologies;
FIG 2 illustrates a schematic diagram of an integrated circuit structure according to an exemplary embodiment of the present disclosure; and
FIG 3 illustrates a schematic diagram of an integrated circuit structure according to another exemplary embodiment of the present disclosure.

### DETAILED DESCRIPTION

Exemplary embodiments are described more comprehensively by referring to the accompanying drawings now. However, the exemplary embodiments can be embodied in many forms and should not be understood as limiting the embodiments set forth herein, and rather, these embodiments are provided so that the present disclosure is thorough and complete, and the concept of exemplary embodiments is fully conveyed to those skilled in the art. Furthermore, the described features, structures, or characteristics may be combined in any suitable manner in one or more embodiments. In the following description, numerous details are provided to provide a thorough understanding of the embodiments of the present disclosure. Those skilled in the art will recognize, however, that the technical solution of the present disclosure may be practiced without providing one or more of the details described, or that other methods, components, devices, steps and so on may be employed. In other cases, well-known technical solutions are not shown or described in detail to avoid obscuring aspects of the present disclosure.

In addition, the accompanying drawings are merely exemplary illustration of the present disclosure, and are not necessarily drawn to scale. The same reference numerals in the drawings denote the same or similar parts, and thus repeated description thereof will be omitted.

In a process of executing a write operation by a memory such as LPDDR4, a DQ input circuit module may obtain a signal transmitted by a DQ port, and the signal cannot be directly processed by a digital circuit due to parasitic effects and various interferences. In this case, the DQ input circuit module samples the obtained DQ signal by means of a DQS signal, and the DQ input circuit module writes the sampled signal into a storage array.

The DQS signal and the DQ signal almost take the same time to reach the LPDDR4, and it may take a while in the LPDDR4 to transmit the DQS signal into the DQ input circuit module, which causes the DQS signal to be out of sync with the DQ signal. To avoid this situation, a semiconductor memory chip may advance transmission of the DQS signal to the LPDDR4 by one tDQS2DQ, such that the DQS signal and the DQ signal can reach the DQ input circuit module synchronously, to improve the accuracy of sampling the DQ signal by the DQ input circuit module.

However, tDQS2DQ is susceptible to factors such as an internal operation voltage or an operation temperature of the LPDDR4. To solve this problem, tDQS2DQ is regulated by continuously detecting variations of parameters such as the internal operation voltage and the operating operation. The detection process consumes time and energy, which results in slow write speed, and influences the operation performance of the memory.

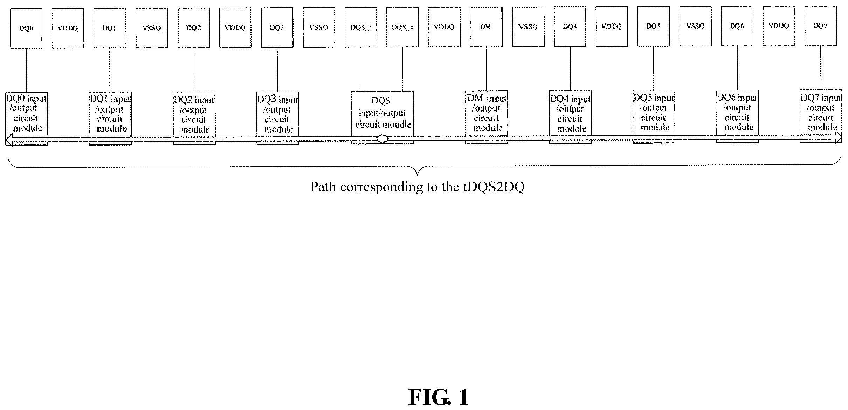

FIG 1 illustrates a schematic diagram of an integrated circuit structure in some technologies. In these technologies, the DQ input/output circuit module and a signal pad are manufactured and configured together. Therefore, a path through which the obtained DQS signal reaches DQ input/output circuit modules at two ends is long, and the length of path is approximate to the length of a region occupied by the signal pad. In the case where the DQ includes 8 bits ranging from DQ0 to DQ7, if a signal pad pitch is 60µm, the sum of the length of paths through which the DQS signal reaches DQ0 and DQ7 input/output circuit modules is about 1,140µm. In the exemplary embodiments of the present disclosure, the sum of the length of the paths is denoted as the length of path corresponding to the tDQS2DQ.

In view of this, if the path corresponding to the tDQS2DQ is shortened, the effects of the factors such as the operation voltage and the operation temperature on the tDQS2DQ are also reduced. In addition, the shortening of the path can also reduce current consumption and ensure signal integrity. Thus, the write performance of the memory can be improved.

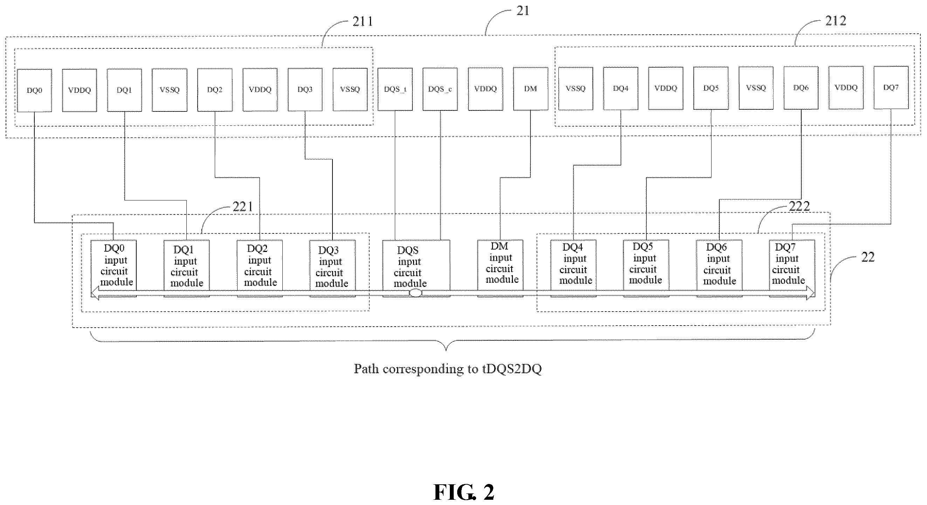

An integrated circuit structure in an exemplary embodiment of the present disclosure is described below with reference to FIG 2.

With reference to FIG 2, the integrated circuit structure includes a pad region 21 and a circuit region 22.

The pad region 21 includes multiple signal pads arranged along a target direction. The signal pads refer to pads corresponding to data signal ports, and may include but be not limited to multiple data input/output pads, a first differential data strobe pad, a second differential data strobe pad, and a data mask pad.

For the multiple data input/output pads, taking the DQ including 8 bits ranging from DQ0 to DQ7 as an example, the multiple data input/output pads include a DQ0 pad, a DQ1 pad, a DQ2 pad, a DQ3 pad, a DQ4 pad, a DQ5 pad, a DQ6 pad, and a DQ7 pad. It is to be understood that the multiple data input/output pads may include 16 pads ranging from DQ0 to DQ15, depending on different types of memories, which is not limited in the present disclosure.

The data input/output pad executes the write operation and the read operation integrally. In a process of executing the write operation, the data input/output pad receives a data signal from a pin through a lead, and transmits the data signal to a corresponding circuit module. In a process of executing the read operation, the data input/output pad receives the data signal from the corresponding circuit module and transmits the data signal through the pin.

In a memory above DDR4, a differential data strobe pad may include a first differential data strobe pad (denoted as DQS_t pad) and a second differential data strobe pad (denoted as DQS_c pad). A signal received by the first differential data strobe pad and a signal received by the second differential data strobe pad have the same amplitude and opposite phases. In a process of sampling using a differential signal, a time point at which two differential signals cross over may be, for example, a time point of sampling, based on which the data signal is sampled.

For the data mask pad (DM pad), a mask signal for executing partial write functions may be inputted. When the received mask signal is at a low level, a bit corresponding to the input data is discarded.

In addition, the pad region 21 may also include multiple power source pads (VDDQ pads) and multiple ground pads (VSSQ pads) to provide a power source terminal and a ground terminal.

According to an embodiment of the present disclosure, the pad region 21 may include a first pad subregion 211 and a second pad subregion 212. The number of data input/output pads contained in the first pad subregion 211 is equal to that of data input/output pads contained in the second pad subregion 212, and the number is half of the total number of the data input/output pads. For example, the first pad subregion 211 includes a DQ0 pad, a DQ1 pad, a DQ2 pad, and a DQ3 pad, and the second pad subregion 212 includes a DQ4 pad, a DQ5 pad, a DQ6 pad, and a DQ7 pad.

In this case, the first differential data strobe pad, the second differential data strobe pad and the data mask pad may be arranged between the first pad subregion 211 and the second pad subregion 212, so that a differential data strobe signal can perform path matching on each DQ input circuit module easily, thereby avoiding the problem of excessive distance difference.

It is to be understood that according to some other embodiments of the present disclosure, any one of the first differential data strobe pad, the second differential data strobe pad and the data mask pad may be arranged on one side of the pad region 21, and positions thereof relative to the data input/output pads are not limited.

The circuit region 22 is arranged on one side of the pad region 21. That is, the circuit region 22 and the pad region 21 are two regions which do not overlap. Corresponding to the multiple signal pads in the pad region 21, the circuit region 22 includes multiple input/output circuit modules arranged along a target direction, and each of the input/output circuit modules is connected to a corresponding signal pad through a metal wire. When executing the write operation, the input/output circuit module is configured to perform sampling operation on the input signal and write a sampling result into the storage array. When executing the read operation, the input/output circuit module is configured to read data stored in the storage array.

The multiple input/output circuit modules may include multiple data input/output circuit modules, a data strobe input/output circuit module, and a data mask input/output circuit module.

For the multiple data input/output circuit modules, corresponding to the multiple data input/output pads described above, the multiple data input/output circuit modules may include a DQ0 input/output circuit module, a DQ1 input/output circuit module, a DQ2 input/output circuit module, a DQ3 input/output circuit module, a DQ4 input/output circuit module, a DQ5 input/output circuit module, a DQ6 input/output circuit module, and a DQ7 input/output circuit module.

Each of the DQ input/output circuit modules may be configured to receive a data signal transmitted by the DQ input/output pad corresponding to the DQ input/output circuit module, and sample the data signal in response to a data strobe signal to write the sampling result into the storage array.

The data strobe input/output circuit module may be configured to transmit the data strobe signal to each of the DQ input/output circuit modules.

The data mask input/output circuit module may be configured to obtain mask information and execute corresponding partial write operations.

According to an embodiment of the present disclosure, the circuit region 22 includes a first circuit subregion 221 and a second circuit subregion 222. The number of data input/output circuit modules contained in the first circuit subregion 221 is equal to that of data input/output circuit modules contained in the second circuit subregion 222, and the number is half of the total number of the data input/output circuit modules. For example, the first circuit subregion 221 includes a DQ0 input/output circuit module, a DQ1 input/output circuit module, a DQ2 input/output circuit module, and a DQ3 input/output circuit module, and the second circuit subregion 222 includes a DQ4 input/output circuit module, a DQ5 input/output circuit module, a DQ6 input/output circuit module, and a DQ7 input/output circuit module.

In this case, the data strobe input/output circuit module and the data mask input/output circuit module are arranged between the first circuit subregion 221 and the second circuit subregion 222.

In addition, referring to FIG 2, the data strobe input/output circuit module may be connected to the first differential data strobe pad and the second differential data strobe pad through metal wires.

In an exemplary embodiment of the present disclosure, a size of the circuit region 22 along a target direction is smaller than that of the pad region 21 along the target direction. As described above, the size of the circuit region 22 along the target direction refers to the length of the circuit region 22 along a direction in which the multiple input/output circuit modules are arranged, that is, the length of a path corresponding to the tDQS2DQ.

The size of the circuit region 22 along the target direction is configured to be less than that of the pad region 21 along the target direction. In one aspect, the length of a path for transmitting the DQS signal to the DQ input/output circuit module is reduced, and further the tDQS2DQ value is reduced. In another aspect, a shorter path can alleviate the temperature and voltage interferences, which can greatly improve temperature and voltage performances and can reduce current consumption, thereby ensuring signal integrity and improving memory performance.

According to some embodiments of the present disclosure, in the circuit region 22, a distance between adjacent input/output circuit modules is smaller than a distance threshold. The distance threshold may be determined according to the size of the pad region 21 along the target direction and the size of each input/output circuit module along the target direction, such that the size of the circuit region 22 along the target direction is smaller than the size of the pad region 21 along the target direction. It is to be noted that distances between adjacent input/output circuit modules may be the same or may be different.

As shown in FIG 2, there may be a gap between adjacent input/output circuit modules to avoid mutual interference between the modules.

In addition, the size of the circuit region along the target direction may be set to be smaller.

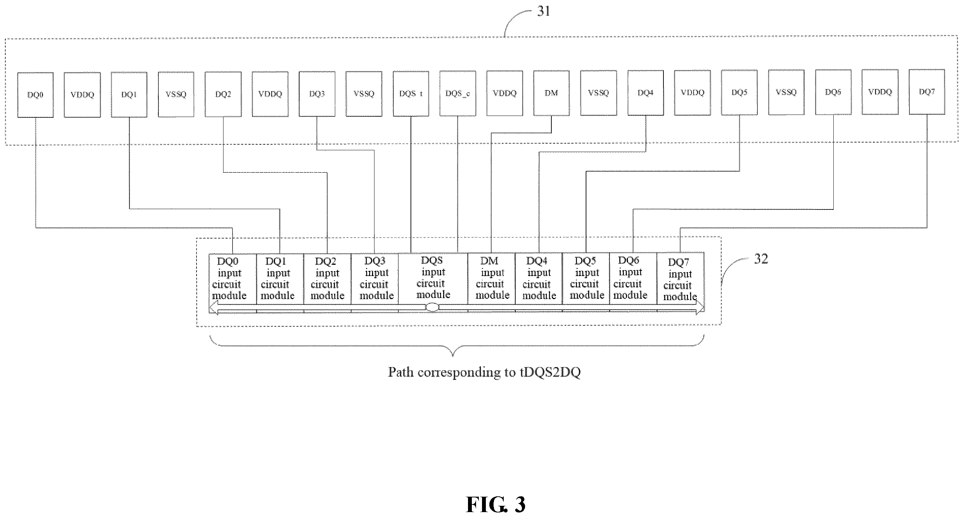

Referring to FIG 3, the pad region 31 is the same as the pad region 21 in FIG 2, and thus is not to be described again. For the circuit region 32, the distance between adjacent input/output circuit modules may be as small as possible. That is, the above-mentioned distance threshold may be set as small as possible. In adjacent structures configured as shown in FIG 3, the path length corresponding to the tDQS2DQ is further shortened, and more space may be saved in the fabrication processes.

Regarding the exemplary structures as shown in FIG 3, the path corresponding to the tDQS2DQ is about 700µm. Compared with the 1,140µm in some technologies in FIG 1, the path length is greatly reduced.

According to some embodiments of the present disclosure, in the integrated circuit structure as shown in FIG 2 or FIG 3, a width-to-depth ratio of the region occupied by each of the input/output circuit modules along the target direction is less than a ratio threshold. In the invention, the length of each of the input/output circuit modules along the target direction may be configured to be shorter. In order to not affecting functions of the modules, in this case, the length of each of the input/output circuit modules along a direction perpendicular to the target direction may be appropriately increased. A value of the ratio threshold is not limited in the present disclosure.

In addition, with reference to FIG 2 or FIG 3, in the embodiments of the present disclosure, the metal wire from the pad to the input/output circuit module may be configured to be narrow, and thus a large current drive is not required, and input capacitance can be reduced.

The present disclosure further provides a memory, which includes any one of the above-mentioned integrated circuit structures.

It is to be understood that the present disclosure does not limit the type of the memory, which may be a DDR4 SDRAM such as LPDDR4, or may be a DDR5 memory, etc.

Other embodiments of the present disclosure will be apparent to those skilled in the art from consideration of the specification and practice of the present disclosure disclosed here. The present disclosure is intended to cover any variations, usage, or adaptations of the present disclosure following the general principles thereof and including such departures from the present disclosure as come within known or customary practice in the art. It is intended that the specification and embodiments be considered as exemplary only, with a true scope of the present disclosure being indicated by the following claims.

It will be appreciated that the present disclosure is not limited to the exact construction that has been described above and illustrated in the accompanying drawings, and that various modifications and changes can be made without departing from the scope thereof. It is intended that the scope of the present disclosure only be limited by the appended claims.

## Claims

1. An integrated circuit structure comprising:
a pad region (21) comprising a plurality of signal pads arranged along a target direction; and
a circuit region (22) arranged on one side of the pad region (21), wherein the circuit region (22) comprises a plurality of input/output circuit modules which are arranged along the target direction and correspondingly connected to the plurality of signal pads, and each of the plurality of input/output circuit modules is configured to perform a sampling operation of an input signal, write a sampling result into a storage array, and read data stored in the storage array,
wherein a size of the circuit region (22) along the target direction is less than that of the pad region (21) along the target direction,
wherein a width-to-depth ratio of a region occupied by each of the plurality of input/output circuit modules along the target direction is less than a ratio threshold, wherein for each of the plurality of input/output circuit modules, a length of the input/output circuit module along the target direction is less than a length of the input/output circuit module along a direction perpendicular to the target direction.

2. The integrated circuit structure according to claim 1, wherein the plurality of signal pads comprise:
a first differential data strobe pad, a second differential data strobe pad, a data mask pad, and a plurality of data input/output pads.

3. The integrated circuit structure according to claim 2, wherein the pad region (21) further comprises:
a plurality of power source pads and a plurality of ground pads.

4. The integrated circuit structure according to claim 2, wherein the pad region (21) comprises:
a first pad subregion (211) and a second pad subregion (212), wherein a number of data input/output pads in the first pad subregion (211) is the same as that of data input/output pads in the second pad subregion (212), and the number is half of a total number of data input/output pads;
wherein the first differential data strobe pad, the second differential data strobe pad and the data mask pad are arranged between the first pad subregion (211) and the second pad subregion (212).

5. The integrated circuit structure according to claim 4, wherein the plurality of input/output circuit modules comprise:
a data strobe input/output circuit module, a data mask input/output circuit module, and a plurality of data input/output circuit modules.

6. The integrated circuit structure according to claim 5, wherein the circuit region (22) comprises:
a first circuit subregion (221) and a second circuit subregion (222), wherein a number of data input/output circuit modules in the first circuit subregion (221) is the same as that of data input/output circuit modules in the second circuit subregion (222), and the number is half of a total number of data input/output circuit modules;
wherein the data strobe input/output circuit module and the data mask input/output circuit module are arranged between the first circuit subregion (221) and the second circuit subregion (222).

7. The integrated circuit structure according to claim 5, wherein the data strobe input/output circuit module is connected to the first differential data strobe pad and the second differential data strobe pad respectively.

8. The integrated circuit structure according to any one of claims 1 to 7, wherein a distance between the adjacent input/output circuit modules is less than a distance threshold;
wherein the distance threshold is determined based on a size of the pad region (21) along the target direction and a size of each of the plurality of input/output circuit modules along the target direction.

9. A memory, comprising the integrated circuit structure according to any one of claims 1 to 8.

## Patentansprüche

1. Integrierte Schaltungsstruktur, die umfasst:
einen Pad-Bereich (21) mit einer Vielzahl von Signal-Pads, die entlang einer Zielrichtung angeordnet sind; und
einen Schaltungsbereich (22), der auf einer Seite des Pad-Bereichs (21) angeordnet ist, wobei der Schaltungsbereich (22) eine Vielzahl von Eingangs-/Ausgangs-Schaltungsmodulen umfasst, die entlang der Zielrichtung angeordnet und entsprechend mit der Vielzahl von Signal-Pads verbunden sind, und jedes der Vielzahl von Eingangs-/Ausgangs-Schaltungsmodulen so ausgelegt ist, dass es eine Abtastoperation eines Eingangssignals durchführt, ein Abtastergebnis in ein Speicherfeld schreibt und in dem Speicherfeld gespeicherte Daten liest,
wobei eine Größe des Schaltungsbereichs (22) entlang der Zielrichtung kleiner ist als die des Pad-Bereichs (21) entlang der Zielrichtung,
wobei ein Verhältnis von Breite zu Tiefe eines Bereichs, der von jedem der Vielzahl von Eingangs-/Ausgangs-Schaltungsmodulen entlang der Zielrichtung eingenommen wird, kleiner ist als ein Verhältnisschwellenwert, wobei für jedes der Vielzahl von Eingangs-/Ausgangs-Schaltungsmodulen eine Länge des Eingangs-/Ausgangs-Schaltungsmoduls entlang der Zielrichtung kleiner ist als eine Länge des Eingangs-/Ausgangs-Schaltungsmoduls entlang einer Richtung senkrecht zur Zielrichtung.

2. Integrierte Schaltungsstruktur nach Anspruch 1, wobei die Vielzahl von Signal-Pads umfasst:
ein erstes Differential-Daten-Strobe-Pad, ein zweites Differential-Daten-Strobe-Pad, ein Datenmasken-Pad und eine Vielzahl von Daten-Eingangs-/Ausgangs-Pads.

3. Integrierte Schaltungsstruktur nach Anspruch 2, wobei der Pad-Bereich (21) ferner umfasst:
eine Vielzahl von Stromquellen-Pads und eine Vielzahl von Erdungspads.

4. Integrierte Schaltungsstruktur nach Anspruch 2, wobei der Pad-Bereich (21) umfasst:
einen ersten Pad-Unterbereich (211) und einen zweiten Pad-Unterbereich (212), wobei eine Anzahl von Daten-Eingangs-/Ausgangs-Pads in dem ersten Pad-Unterbereich (211) die gleiche ist wie die von Daten-Eingangs-/Ausgangs-Pads in dem zweiten Pad-Unterbereich (212) und die Anzahl die Hälfte einer Gesamtzahl von Daten-Eingangs-/Ausgangs-Pads ist;
wobei das erste Differential-Daten-Strobe-Pad, das zweite Differential-Daten-Strobe-Pad und das Datenmasken-Pad zwischen dem ersten Pad-Unterbereich (211) und dem zweiten Pad-Unterbereich (212) angeordnet sind.

5. Integrierte Schaltungsstruktur nach Anspruch 4, wobei die Vielzahl von Eingangs-/Ausgangs-Schaltungsmodulen umfasst:
ein Daten-Strobe-Eingangs-/Ausgangs-Schaltungsmodul, ein Datenmasken-Eingangs-/Ausgangs-Schaltungsmodul und eine Vielzahl von Daten-Eingangs-/Ausgangs-Schaltungsmodulen.

6. Integrierte Schaltungsstruktur nach Anspruch 5, wobei der Schaltungsbereich (22) umfasst:
einen ersten Schaltungsunterbereich (221) und einen zweiten Schaltungsunterbereich (222), wobei eine Anzahl von Daten-Eingangs-/Ausgangs-Schaltungsmodulen in dem ersten Schaltungsunterbereich (221) die gleiche ist wie die von Daten-Eingangs-/Ausgangs-Schaltungsmodulen in dem zweiten Schaltungsunterbereich (222) und die Anzahl die Hälfte einer Gesamtzahl von Daten-Eingangs-/Ausgangs-Schaltungsmodulen ist;
wobei das Daten-Strobe-Eingangs-/Ausgangs-Schaltungsmodul und das Datenmasken-Eingangs-/Ausgangs-Schaltungsmodul zwischen dem ersten Schaltungsunterbereich (221) und dem zweiten Schaltungsunterbereich (222) angeordnet sind.

7. Integrierte Schaltungsstruktur nach Anspruch 5, wobei das Daten-Strobe-Eingangs-/Ausgangs-Schaltungsmodul mit dem ersten Differential-Daten-Strobe-Pad und dem zweiten Differential-Daten-Strobe-Pad verbunden ist.

8. Integrierte Schaltungsstruktur nach einem der Ansprüche 1 bis 7, wobei der Abstand zwischen den benachbarten Eingangs-/Ausgangs-Schaltungsmodulen kleiner als ein Abstandsschwellenwert ist;
wobei der Abstandsschwellenwert auf der Grundlage einer Größe des Pad-Bereichs (21) entlang der Zielrichtung und einer Größe jedes der Vielzahl von Eingangs-/Ausgangs-Schaltungsmodulen entlang der Zielrichtung bestimmt wird.

9. Speicher, der die integrierte Schaltungsstruktur nach einem der Ansprüche 1 bis 8 umfasst.

## Revendications

1. Structure de circuit intégré comprenant :
une région de pastilles (21) comprenant une pluralité de pastilles de signal agencées le long d'une direction cible ; et
une région de circuit (22) disposée sur un côté de la région de pastilles (21), dans laquelle la région de circuit (22) comprend une pluralité de modules de circuit d'entrée/sortie qui sont agencés le long de la direction cible et connectés de manière correspondante à la pluralité de pastilles de signal, et chacun de la pluralité de modules de circuit d'entrée/sortie est configuré pour effectuer une opération d'échantillonnage d'un signal d'entrée, écrire un résultat d'échantillonnage dans un réseau de stockage et lire des données stockées dans le réseau de stockage,
dans lequel une taille de la région de circuit (22) le long de la direction cible est inférieur à celui de la région de pastilles (21) le long de la direction cible,
dans lequel un rapport largeur sur profondeur d'une région occupée par chacun de la pluralité de modules de circuit d'entrée/sortie le long de la direction cible est inférieur à un seuil de rapport, dans lequel pour chacun de la pluralité de modules de circuit d'entrée/sortie, une longueur du module de circuit d'entrée/sortie le long de la direction cible est inférieure à une longueur du module de circuit d'entrée/sortie le long d'une direction perpendiculaire à la direction de la cible.

2. Structure de circuit intégré selon la revendication 1, dans laquelle la pluralité de pastilles de signal comprend :
une première pastille d'échantillonnage de données différentielles, une deuxième pastille d'échantillonnage de données différentielles, une pastille de masque de données et une pluralité de pastilles d'entrée/sortie de données.

3. Structure de circuit intégré selon la revendication 2, dans laquelle la région de pastilles (21) comprend en outre :
une pluralité de pastilles de source d'alimentation et une pluralité de pastilles de masse.

4. Structure de circuit intégré selon la revendication 2, dans laquelle la région de pastilles (21) comprend :
une première sous-région de pastilles (211) et une seconde sous-région de pastilles (212), dans lequel un nombre de pastilles d'entrée/sortie de données dans la première sous-région de pastilles (211) est le même que celui des pastilles d'entrée/sortie de données dans la seconde sous-région de pastilles (212), et le nombre est la moitié d'un nombre total de pastilles d'entrée/sortie de données ;
dans lequel la première pastille d'échantillonnage de données différentielles, la seconde pastille d'échantillonnage de données différentielles et la pastille de masque de données sont agencées entre la première sous-région de pastilles (211) et la seconde sous-région de pastilles (212).

5. Structure de circuit intégré selon la revendication 4, dans laquelle la pluralité de modules de circuit d'entrée/sortie comprend :
un module de circuit d'entrée/sortie d'échantillonnage de données, un module de circuit d'entrée/sortie de masque de données et une pluralité de modules de circuit d'entrée/sortie de données.

6. Structure de circuit intégré selon la revendication 5, dans laquelle la région de circuit (22) comprend :
une première sous-région de circuit (221) et une seconde sous-région de circuit (222), dans lequel un nombre de modules de circuit d'entrée/sortie de données dans la première sous-région de circuit (221) est le même que celui des modules de circuit d'entrée/sortie de données dans la seconde sous-région de circuit (222), et le nombre est la moitié d'un nombre total de modules de circuit d'entrée/sortie de données ;
dans lequel le module de circuit d'entrée/sortie d'échantillonnage de données et le module de circuit d'entrée/sortie de masque de données sont agencés entre la première sous-région de circuit (221) et la seconde sous-région de circuit (222).

7. Structure de circuit intégré selon la revendication 5, dans laquelle le module de circuit d'entrée/sortie d'échantillonnage de données est connecté respectivement à la première pastille d'échantillonnage de données différentielles et à la deuxième pastille d'échantillonnage de données différentielles.

8. Structure de circuit intégré selon l'une quelconque des revendications 1 à 7, dans laquelle une distance entre les modules de circuit d'entrée/sortie adjacents est inférieure à un seuil de distance ;
dans lequel le seuil de distance est déterminé sur la base d'une taille de la région de pastilles (21) le long de la direction cible et d'une taille de chacun de la pluralité de modules de circuit d'entrée/sortie le long de la direction cible.

9. Mémoire, comprenant la structure de circuit intégré selon l'une quelconque des revendications 1 à 8.
